# EUROPEAN PATENT APPLICATION

(11) **EP 4 518 617 A2**
(43) Date of publication of application: **05.03.2025**
(21) Application number: 25151049.1
(22) Date of filing: 29.01.2023
(51) Int. Cl.: H10H 20/831

(54) **MICRO-LED DISPLAY PANEL**

(62) Divisional of application: 23918117.5
(71) Applicant: Jade Bird Display (Shanghai) Limited, Shanghai 201306 (CN)
(72) Inventor: XU, Huiwen, Shanghai, 201306 (CN); LI, Qiming, Shanghai, 200120 (CN); GUO, Jian, Shanghai, 200120 (CN); XU, Qunchao, Shanghai, 200120 (CN)
(74) Representative: Finnegan Europe LLP

(57) **Abstract**

A micro-LED display panel is provided. The panel includes a micro pixel array area having plurality of micro pixel areas, each micro pixel area comprising a micro-LED, wherein the micro-LED comprises at least two light emitting layers disposed in a vertical direction and a dielectric layer formed between adjacent ones of the light emitting layers, wherein the at least two light emitting layers are off-axial, an IC backplane formed at a back surface of the micro-LED and configured to control the light emitting layers, and a plurality of interconnected structures configured to electrically respectively connect the light emitting layer to electrodes. The interconnected structures comprises one or more top interconnected structures configured to electrically connect a top of each of the light emitting layers to a first electrode, and one or more bottom interconnected structures configured to electrically connect a bottom of each of the light emitting layers to the IC backplane to a second electrode, the interconnected structures being formed around each micro pixel area, one bottom interconnected structure corresponding to one micro-LED, and one top interconnected structure corresponding to adjacent micro-LEDs.

## Description

### TECHNICAL FIELD

The present disclosure generally relates to micro-LED manufacturing technology, and more particularly, to a micro-LED display panel.

### BACKGROUND

Inorganic micro pixel light emitting diodes, also referred to as micro light emitting diodes, micro-LEDs or µ-LEDs, become more and more important since they are used in various areas including self-emissive micro-displays, visible light communications, and optogenetics. The micro-LEDs have higher output performance than conventional LEDs because of better strain relaxation, improved light extraction efficiency, and uniform current spreading. Compared with conventional LEDs, the micro-LEDs also exhibit several advantages, such as improved thermal effects, faster response rate, larger working temperature range, higher resolution, wider color gamut, higher contrast, lower power consumption, and operability at higher current density.

Conventionally, the micro-LEDs can include multiple light emitting layers, and each light emitting layer can be electrically connected to a respective electrode, so that each light emitting layer can be controlled. A micro-LED display panel may include an array of micro-LEDs. Therefore, for a micro-LED display panel, such connections for each light emitting layer of each micro-LED costs significant space within the micro-LED display panel, which could constrain arranging more micro-LEDs on the micro-LED display panel.

### SUMMARYOF THE DISCLOSURE

Embodiments of the present disclosure provide a micro-LED display panel. The micro-LED display panel includes a micro pixel array area comprising a plurality of micro pixel areas, each micro pixel area comprising a micro-LED; wherein the micro-LED comprises at least two light emitting layers in a vertical direction and a dielectric layer formed between adjacent ones of the light emitting layers, wherein the at least two light emitting layers are coaxial; an IC backplane formed at a back surface of the micro-LED and configured to control the light emitting layers; and a plurality of interconnected structures configured to electrically connect each light emitting layer to electrodes respectively, wherein the interconnected structures comprises one or more top interconnected structures configured to electrically respectively connect a top of each of the light emitting layers to a first electrode, and one or more bottom interconnected structures configured to electrically connect a bottom of each of the light emitting layers to the IC backplane to a second electrode, the interconnected structures being formed around each micro pixel area, one bottom interconnected structure corresponding to one micro-LED, and one top interconnected structure corresponding to adjacent micro-LEDs.

Embodiments of the present disclosure provide a micro-LED display panel. The micro-LED display panel includes a micro pixel array area including a plurality of micro pixel areas, each micro pixel area including a micro-LED; wherein the micro-LED comprises at least two light emitting layers disposed in a vertical direction and a dielectric layer formed between adjacent ones of the light emitting layers, wherein the at least two light emitting layers are off-axial; an IC backplane formed at a back surface of the micro-LED and configured to control the light emitting layers; and a plurality of interconnected structures configured to electrically respectively connect the light emitting layer to electrodes, wherein the interconnected structures includes one or more top interconnected structures configured to electrically connect a top of each of the light emitting layers to a first electrode, and one or more bottom interconnected structures configured to electrically connect a bottom of each of the light emitting layers to the IC backplane to a second electrode, the interconnected structures being formed around each micro pixel area, one bottom interconnected structure corresponding to one micro-LED, and one top interconnected structure corresponding to adjacent micro-LEDs.

Embodiments of the present disclosure provide a micro-LED display panel. The micro-LED display panel includes a micro pixel array area comprising a plurality of micro pixel areas, each micro pixel area comprising a micro-LED; wherein the micro-LED comprises at least two light emitting layers disposed in a vertical direction and a dielectric layer formed between adjacent ones of the light emitting layers; an IC backplane formed at a back surface of the micro-LED and configured to control the light emitting layers; a plurality of interconnected structures configured to electrically respectively connect the light emitting layer to electrodes, wherein the interconnected structures comprises one or more top interconnected structures configured to electrically connect a top of each of the light emitting layers to a first electrode, and one or more bottom interconnected structures configured to electrically connect a bottom of each of the light emitting layers to the IC backplane to a second electrode, the interconnected structures being formed around each micro pixel area, one bottom interconnected structure corresponding to one micro-LED, and one top interconnected structure corresponding to adjacent micro-LEDs; and a plurality of the top contacts configured to connect the one or more top interconnected structures to the first electrode, wherein the top contacts are continuously connected to form a mesh structure with the micro-LED being exposed.

### BRIEF DESCRIPTION OF THE DRAWINGS

Embodiments and various aspects of the present disclosure are illustrated in the following detailed description and the accompanying figures. Various features shown in the figures are not drawn to scale.
**FIG. 1** illustrates a structural diagram showing a top view of a micro package structure of a micro-LED display panel, according to some embodiments of the present disclosure.
**FIG. 2** illustrates a structural diagram showing a side sectional view of a micro-LED display panel, according to some embodiments of the present disclosure.
**FIG. 3** illustrates a structural diagram showing a section view of an exemplary micro-LED with multiple light emitting layers, according to some embodiments of the present disclosure.
**FIG. 4A** illustrates a structural diagram showing a top view of an exemplary micro-LED display panel, according to some embodiments of the present disclosure.
**FIGs. 4B** to **4D** are structural diagrams each showing a top view of an exemplary micro-LED display panel illustrating separated zones of metal area, according to some embodiments of the present disclosure.
**FIG. 5A** illustrates a structural diagram showing a section view along an X axis of the exemplary micro-LED display panel shown in **FIG. 4D****,** according to some embodiments of the present disclosure.
**FIG. 5B** illustrates a structural diagram showing a section view along a Y axis of the exemplary micro-LED display panel shown in **FIG. 4D****,** according to some embodiments of the present disclosure.
**FIG. 5C** illustrates a structural diagram showing a section view along a Z axis of the exemplary micro-LED display panel shown in **FIG. 4D****,** according to some embodiments of the present disclosure.
**FIG.** 6 illustrates a structural diagram showing a section view along an X axis of another exemplary micro-LED display panel, according to some embodiments of the present disclosure.

### DETAILED DESCRIPTION

Reference will now be made in detail to exemplary embodiments, examples of which are illustrated in the accompanying drawings. The following description refers to the accompanying drawings in which the same numbers in different drawings represent the same or similar elements unless otherwise represented. The implementations set forth in the following description of exemplary embodiments do not represent all implementations consistent with the invention. Instead, they are merely examples of apparatuses and methods consistent with aspects related to the invention as recited in the appended claims. Particular aspects of the present disclosure are described in greater detail below. The terms and definitions provided herein control, if in conflict with terms and/or definitions incorporated by reference.

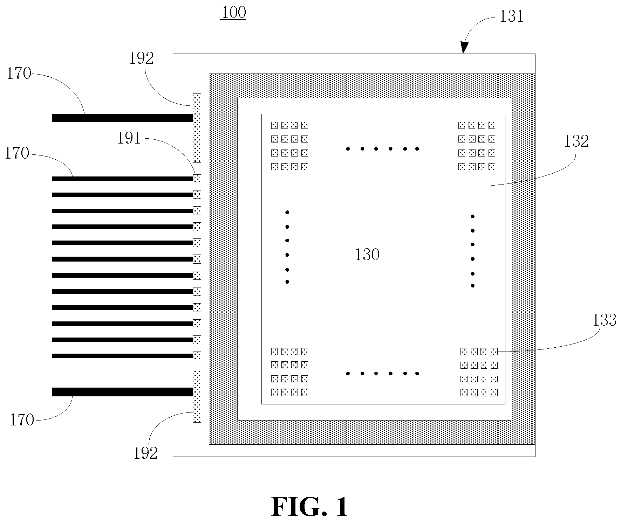

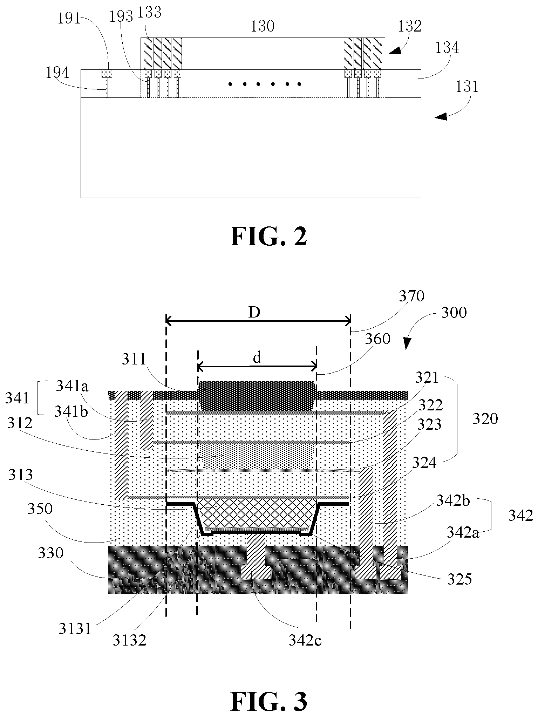

**FIG. 1** illustrates a structural diagram showing a top view of a micro package structure of a micro-LED display panel, according to some embodiments of the present disclosure. **FIG. 2** illustrates a structural diagram showing a side sectional view of a micro-LED display panel, according to some embodiments of the present disclosure. Referring to **FIG. 1** and **FIG. 2****,** a micro package structure 100 includes a micro-LED display panel 130. The micro-LED display panel 130 includes a micro-LED array area 132 and an IC (integrated circuit) backplane 131. The micro-LED array area 132 is located on the IC backplane 131 to form an image display area of the micro-LED display panel 130. The rest of the area on the IC backplane 131 not covered by the micro-LED array area 132 is formed as a non-functional area. The IC backplane 131 is formed at the back surface of the micro-LED array area 132 with an extruded part extending outside of, i.e., not covered by, the micro-LED array area 132. The micro-LED array area 132 further includes a plurality of micro-LEDs 133 provided in an array. A plurality of signal metal pads and dummy metal can be further formed on a surface of the non-functional area. The signal metal pads can include a plurality of IO (input/output) metal pads 191 and a plurality of dummy metal pads 192.

The IO metal pads 191 can conductively connect to the IC backplane 131. The micro-LEDs 133 in the micro-LED array area 132 are connected with the IC backplane 131 by a plurality of first metal connected holes 193, respectively. That is, every micro-LED 133 is connected with the IC backplane 131 by one first metal connected hole 193. Respective tops of the first metal connected holes 193 are connected with the micro-LEDs 133 one-to-one. Accordingly, the plurality of first metal connected holes 193 correspond to the plurality of micro-LED 133. As shown in **FIG. 1****,** the first metal connected holes 193 are formed in an array which is the same as the array ofmicro-LED133, and the first metal connected holes 193 are formed as a first connected area on the IC backplane 131, which corresponds to the micro-LED array area 132 (e.g., the image display area). Bottoms of the signal metal pads, i.e., the IO metal pads 191, and the dummy metal pads 192, are connected with the IC backplane 131 by a plurality of second metal connected holes 194. Bottoms of the second metal connected holes 194 of the IO metal pads 191 are conductively connected with bottoms of the first metal connected holes 193, for example, by wires (not shown) integrated in IC backplane 131. Therefore, the IO metal pads 191 can conductively connect with the micro-LEDs 133 through the second metal connected holes 194, the IC backplane 131, and the first metal connected holes 193. The bottoms of the second metal connected holes 194 of the dummy metal pads 192 are conductively connected with electrodes of the micro-LEDs 133. The second metal connected holes 194 are formed as a second connected area on the non-functional area. The second connected area is disposed away from the first connected area, and close to the edge of the IC backplane 131. In some embodiments, the first connected area refers to an internal connected area, and the second connected area refers as to an external connected area. The first metal connected holes 193 and the second metal connected holes 194 are formed in a top layer 134 of the IC backplane 131.

**FIG. 3** illustrates a structural diagram showing a section view of an exemplary micro-LED 300 with multiple light emitting layers, according to some embodiments of the present disclosure. It can be understood that the components shown in **FIG. 3**are only for illustrative purposes, which will not constitute a limitation of a specific arrangement. As shown in **FIG. 3****,** in this example, micro-LED 300 includes three light emitting layers: a first light emitting layer 311 (i.e., a top-most light emitting layer), a second light emitting layer 312, and a third light emitting layer 313 (i.e., a bottom-most light emitting layer). For example, in some embodiments, the first light emitting layer 311 is a red light emitting layer, the second light emitting layer 312 is a blue light emitting layer, and the third light emitting layer 313 is a green light emitting layer. In some embodiments, the light emitting layers may include a same color light. For example, the first light emitting layer 311 is a green light emitting layer, both the second light emitting layer 312 the third light emitting layer 313 are red light emitting layer. The three light emitting layers (i.e., layer 311 to 313) are arranged in a relative sense, in a vertical direction, from top to bottom. That is, second light emitting layer 312 is disposed over third light emitting layer 313 and first light emitting layer 311 is disposed over second light emitting layer 312.In some embodiments, a vertical distance between two adjacent light emitting layers is the same. In some embodiments, the distance between two adjacent light emitting layers may vary, depending on a practice design.

In some embodiments, the light emitting layers are arranged coaxially. That is, vertical projections of the respective light emitting layers are overlapped. In some embodiments, the size (e.g., area) of light emitting layers can be different. Then, the vertical projections of the respective light emitting layers may be partially overlapped.

In some embodiments, the light emitting layers are arranged off-coaxially. Therefore, the vertical projections of the respective light emitting layers may be partially overlapped. In some embodiments, the light emitting layers are staggered. In some embodiments, the vertical projections of the respective light emitting layers are scattered without any portion overlapped.

In some embodiments, micro-LED 300 further includes a conductive layer network structure 320. Conductive layer network structure 320 is configured to connect each light emitting layer with electrode respectively, so that a potential difference can be formed for the light emitting layer. In some embodiments, conductive layer network structure 320 includes a plurality of conductive layers, for example, conductive layers 321 to 324. Conductive layers 321 and 323 are formed on a back surface of each of first light emitting layer 311 and second light emitting layer 312, respectively, and conductive layers 321 and 323 can also be referred to as bottom conductive layers of first light emitting layer 311 and second light emitting layer 312, respectively. Conductive layers 322 and 324 are formed on a top surface of each of second light emitting layer 312 and third light emitting layer 313, respectively, and conductive layers 322 and 324 can also be referred to as top conductive layers of second light emitting layer 312 and third light emitting layer 313, respectively. Each conductive layer is configured to connect a corresponding light emitting layer to one electrode. With the conductive layer network structure 320, the arrangement of connecting light emitting layers to electrodes can be more flexible, which may provide more possibilities for wiring.

In some embodiments, the conductive layers are transparent. The material of each conductive layer is one or more of Indium Tin Oxides (ITO), Fluorine-doped Tin Oxide (FTO), or Aluminum-doped Zinc Oxide (AZO), etc.

In some embodiments, a bottom conductive layer is formed on a back surface of each of third light emitting layer 313, and the bottom conductive layer is not transparent, so that the light emitting efficiency can be improved.

In some embodiments, micro-LED 300 further includes an interconnected structure, configured to connect the conductive layer network structure 320 to electrodes. In some embodiments, an electrode on the top of the micro-LED 300, and another electrode integrated in an IC backplane 330.The IC backplane 330 is formed on the back surface of the micro-LED 300. The interconnected structure includes one or more top interconnected structures 341 and one or more bottom interconnected structures 342. Top interconnected structure 341 includes top interconnected structures 341a and 341b. Bottom interconnected structure 342 includes bottom interconnected structures 342a and 342b. Top interconnected structures 341 are used to connect tops of the respective light emitting layers, for example, via the conductive layer network structure 320, to the one electrode (not shown) of the micro-LED 300. Bottom interconnected structures 342 are used to connect bottoms of each light emitting layer, for example, via the conductive layer network structure 320, to the IC backplane 330 to connect with another electrode. In some embodiments, each conductive layer (321, 322, 323, or 324) can be connected to one interconnected structure respectively. In some embodiments, a top interconnected structure can be used for connecting respective the tops of the light emitting layers except the top of the top-most light emitting layer (i.e., 311). That is, the top of the top-most light emitting layer 311 can be connected to an electrode (not shown) of micro-LED 300 directly, and the tops of the other light emitting layers (i.e., 312, 313) are connected to a same top interconnected structure 341 via conductive layer network structure 320. In some embodiments, the electrode connecting to the tops of the light emitting layers is provided on the IC backplane. For example, micro-LED 300 further includes an external wire configured to connecting the top interconnected structures to the electrode on the IC backplane. In another example, the top interconnected structure can be extended downward to the IC backplane for connecting the extrude on the IC backplane.

In some embodiments, every light emitting layer 311-313 corresponds to one bottom interconnected structure 342, and all the bottom interconnected structures 342 are separated and insulated from each other. Bottoms of the respective light emitting layers 311-313 are connected to the corresponding bottom interconnected structures 342 respectively via the conductive layer network structure 320. In some embodiments, the bottom of the bottom-most light emitting layer can be connected to the IC backplane 330 directly via the bottom interconnected structure 342 without the conductive layer network structure 320. In some embodiments, the interconnected structure (e.g., top interconnected structure 341 and bottom interconnected structure 342) is made of conductive metal.

In some embodiments, the interconnected structures are further configured to reflect light emitted from the light emitting layers and prevent light across talk between adjacent micro-LEDs, thereby improving the light emitting efficiency. Further details will be described below.

Still with reference to **FIG. 3****,** in this example, the bottom of first light emitting layer 311 is connected to IC backplane 330 via conductive layer 321 and bottom interconnected structure 342a. The top of second light emitting layer 312 is connected to the electrode of micro-LED 300 via conductive layer 322 of conductive layer network structure 320 and top interconnected structure 341a. The bottom of second light emitting layer 312 is connected to IC backplane 330 via conductive layer 323 and bottom interconnected structure 342b. The top of third light emitting layer 313 is connected to the electrode of micro-LED 300 via conductive layer 324 of conductive layer network structure 320 and top interconnected structure 341b. The bottom of third light emitting layer 313 is connected to IC backplane 330 via a conductive layer and bottom interconnected structure. As shown in **FIG. 3****,** the bottom of the third light emitting layer 313 can be connected to the IC backplane without a bottom conductive layer. The bottom of third light emitting layer 313 (i.e., the bottom-most light emitting layer) is connected to IC backplane 330 by a bottom conductive connected structure 380. Therefore, one bottom interconnected structure can be saved. The number of bottom interconnected structures in a micro-LED is less than the number of light emitting layers by one. For example, when there are three light emitting layers in a micro-LED, the number of the bottom interconnected structure for the micro-LED is 2. If there are five light emitting layers in a micro-LED, the number of the bottom interconnected structure for the micro-LED is 4. In some embodiments, bottom conductive layer 325 can be formed on a back surface of third light emitting layer 313, and bottom conductive connected structure 380 is connected to bottom conductive layer 325. In some embodiments, there is no conductive layer formed on the back surface of the third light emitting layer 313. That is, bottom conductive connected structure 380 can be connected to third light emitting layer 313 without bottom conductive layer 325.

Each light emitting layer is connected to the electrodes respectively, so that each light emitting layer can be controlled independently. In some embodiments, each light emitting layer is a stacked P-N junction layer. In some embodiments, the stacked P-N junction layer includes a P-type semiconductor layer, a quantum well layer and an N-type semiconductor layer from top to bottom.

In some embodiments, micro-LED 300 further includes a dielectric layer 350, which is formed between the adjacent light emitting layers. For example, a first dielectric layer is formed between first light emitting layer 311 and second light emitting layer 312, a second dielectric layer is formed between second light emitting layer 312 and third light emitting layer 313, and a third dielectric layer can be further formed between third light emitting layer 313 and IC backplane330. In some embodiments, dielectric layer 350 is formed around interconnected structure. In some embodiments, dielectric layer 350 fills the space within the micro-LED 300. In some embodiments, the dielectric layer 350 is transparent. In some embodiments, the material of dielectric layer 350 includes one or more of SiO₂, SiON, Al₂O₃ or SiN, etc.

In some embodiments, third light emitting layer 313, i.e., the bottom-most light emitting layer, further includes a reflective layer 3131 formed on a bottom surface of third light emitting layer 313. Reflective layer 3131 is non-transparent and can upward reflect light emitted to the bottom of the bottom-most light emitting layer 313 to improve the emitting efficiency. In some embodiments, reflective layer 3131 is an Ag mirror.

In some embodiments, third light emitting layer 313, i.e., the bottom-most light emitting layer, further includes an isolation layer 3132 formed between the bottom surface of third light emitting layer 313 and reflective layer 3131 to isolate third light emitting layer 313 from reflective layer 3131. In some embodiments, the material of isolation layer 3132 includes one or more of SiO₂, SiON, Al₂O₃ or SiN, etc.

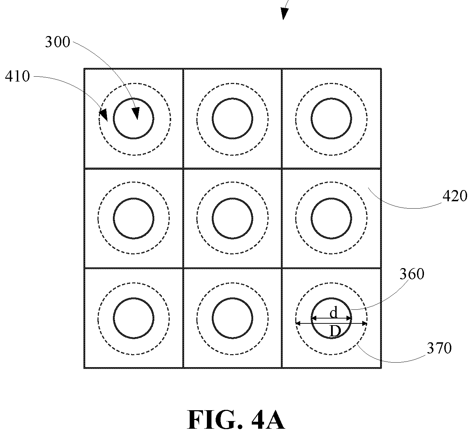

**FIG. 4A** illustrates a structural diagram showing a top view of an exemplary micro-LED display panel 400, according to some embodiments of the present disclosure. As shown in **FIG. 4A****,** the micro-LED display panel 400 includes a micro pixel array area. In this example, the micro pixel array area is a 3×3 array. The micro pixel array area includes a plurality of micro-LED pixel areas 410. Each of the micro pixel areas 410 in the micro pixel array area includes a micro-LED 300. Referring also to **FIG. 3****,** each micro-LED 300 may be defined with a mesa boundary 360 and a metal boundary 370. Mesa boundary 360 defines a mesa structure area of micro-LED 300. The mesa structure has a diameter d and is formed by light emitting layers (e.g., 311, 312, or 313). For example, a diameter of mesa boundary 360 is d. In some embodiments, the mesa structure has a convex structure. In some embodiments, the mesa structure includes a flat top surface. In some embodiments, a top surface of the mesa structure is aligned with a surface of micro-LED 300, that is, the mesa structure does not protrude from a surface of micro-LED 300. Metal boundary 370 separates micro-LED 300 from a metal area. The area defined within the metal boundary 370 forms a micro-LED pixel area 410 for emitting light. In some embodiments, a little light can be emitted from an area outside of metal boundary 370. For example, a diameter of metal boundary 370 is D. An area between adjacent micro-LEDs 300 can be referred to as a metal area 420. Metal can be filled in metal area 420 partially or fully and serves as an emission blocker to prevent optical cross-talk between adjacent micro-LEDs 300.

In some embodiments, referring to **FIG. 3****,** micro-LED 300 further includes a micro lens 390 above first light emitting layer 311. Micro lens 390 covers an area of the mesa structure (i.e., mesa structure area) of micro-LED 300, that is, a diameter of micro lens 390 is equal to or greater than diameter d. In some embodiments, the diameter of micro lens 390 is less than or equal to diameter D. The material of the micro lens 390 is selected from silicon oxide, photo resist, etc.

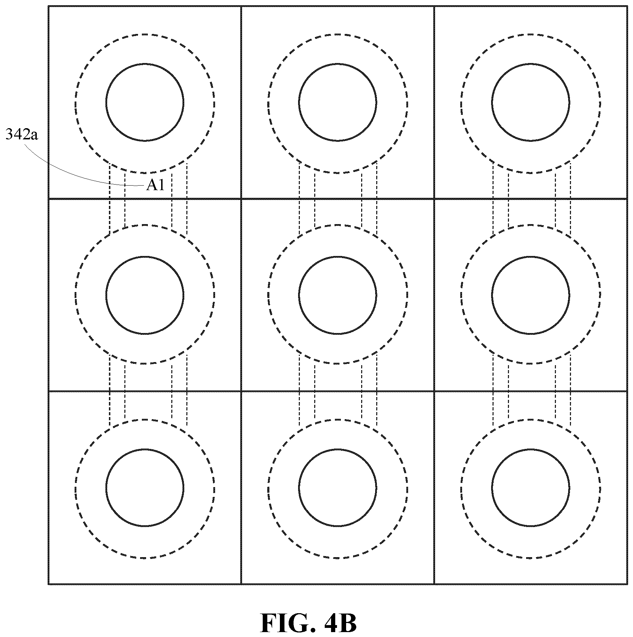

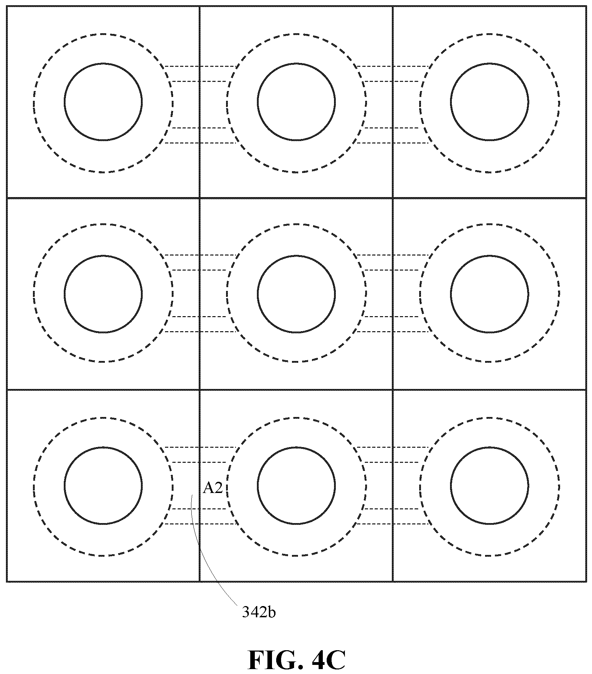

**FIGs. 4B** to **4D** are structural diagrams each showing a top view of an exemplary micro-LED display panel illustrating separated zones of metal area 420, according to some embodiments of the present disclosure. Referring to **FIG.** 3 and **FIGs. 4B** to **4D,** in some embodiments, metal area 410 can be divided into a plurality of zones for providing different functions. For example, metal area 410 can be divided into a first zone for connecting the bottom of each light emitting layer to IC backplane 330, and a second zone for connecting the top of each light emitting layer to the electrode of micro-LED. In this example, for a micro-LED with three light emitting layers, the first zone for connecting bottoms of each light emitting layer to IC backplane 330 is divided into two sub-zones A1 and A2. **FIG. 4B** and **FIG. 4C** illustrate sub-zone A1 and sub-zone A2, respectively, according to some embodiments of the present disclosure. As shown in **FIG. 4B****,** sub-zone A1 is a zone connecting adjacent micro-LEDs in a vertical direction as viewed in **FIG. 4B****.** A bottom interconnected structure 342a for connecting to the bottom of first light emitting layer 321 can be provided in the sub-zone A1. As shown in **FIG. 4C****,** sub-zone A2 is a zone connecting adjacent micro-LEDs in a horizontal direction as viewed in **FIG. 4C****.** A bottom interconnected structure 342b for connecting to the bottom of second light emitting layer 312 can be provided in the sub-zone A2. In some embodiments, a bottom interconnected structure for connecting to the bottom of third light emitting layer 313 can be provided under the bottom of the micro-LED, e.g., within mesa boundary 360. In some embodiments, the third light emitting layer 313 can be connected to the IC backplane without a bottom conductive layer. The bottom of third light emitting layer 313 (i.e., the bottom-most light emitting layer) is connected to the IC backplane by a bottom conductive connected structure, which is formed between the bottom of the bottom-most light emitting layer and the IC backplane. Therefore, the bottom interconnected structure is not required for the third light emitting layer 313. Accordingly, the number of bottom interconnected substructures of a micro-LED can be reduced by one. For example, when there are three light emitting layers in a micro-LED, the number of the bottom interconnected structure for the micro-LED is 2. If there are five light emitting layers in a micro-LED, the number of the bottom interconnected structures for the micro-LED is 4.

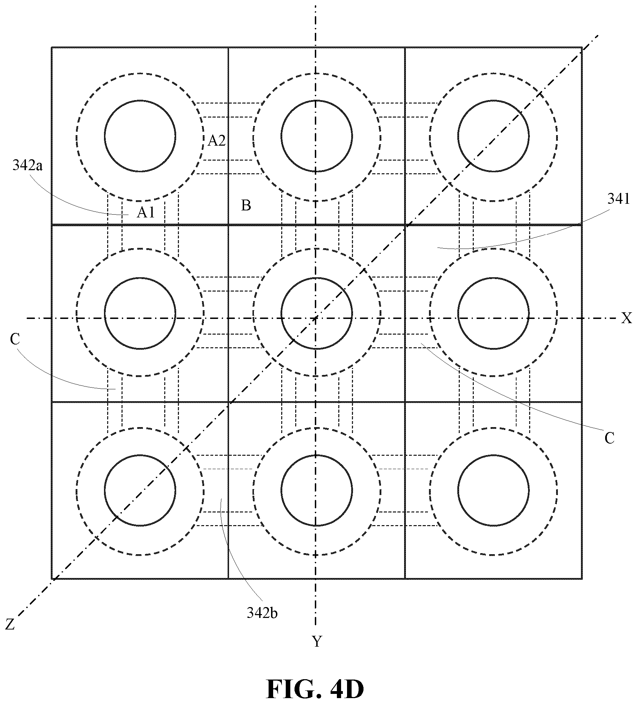

Sub-zone A1 and sub-zone A2 are separated. More particularly, bottom interconnected structure 342a and bottom interconnected structure 342b are separately arranged. **FIG. 4D** illustrates the sub-zones A1, A2 and a second zone B for connecting tops of respective light emitting layer to the electrode of the micro-LED, according to some embodiments of the present disclosure. As shown in **FIG. 4D****,** zone B can be formed within the remaining area between sub-zone A1 and sub-zone A2. In this example, sub-zone A1 and sub-zone A2 are orthogonal, so zone B is a rectangle. Top interconnected structure 341 for connecting the tops of respective light emitting layer (e.g., 311 to 313) can be provided in zone B.

As shown in **FIG. 4D****,** the zones A1, A2, and B are divided symmetrically, with sub-zone A1 and sub-zone A2 being separated. It can be understood that, in some embodiments, sub-zone A1 and sub-zone A2 are not orthogonal. There is an isolation zone between adjacent zones, configured to separate adjacent zones, and there is no metal filled in the isolation zone. For example, referring to **FIG. 4D****,** a zone C is formed between sub-zone A1 and zone B, and between sub-zone A2 and zone B.

In some embodiments, bottom interconnected structures 342 are symmetrically arranged around each of the micro pixel areas, for example, in sub-zone A1 and sub-zone A2, as shown in **FIG. 4D****.** In some embodiments, the top interconnected structures 341 are symmetrically arranged around each of the micro pixel area, for example, at the centers of zone B as shown in **FIG. 4D****.** In some embodiments, the symmetric center of bottom interconnected structures 342and top interconnected structures 341 is the center of each micro-LED.

In some embodiments, there are more than three light emitting layers in a micro-LED. The first zone for connecting bottoms of respective light emitting layers to the IC backplane can be further divided into more sub-zones. For example, for a micro-LED having four light emitting layers, three sub-zones of a first one of the zones can be separated by an angle 120° between two sub-zones. Three bottom interconnected structures corresponding to three light emitting layers can be provided in the three sub-zones respectively. The bottom interconnected structure for the bottom-most light emitting layer can be provided in a mesa structure area, e.g., within the mesa boundary. A second zone for connecting tops of respective light emitting layers to the electrode of the micro-LED can be formed within the remaining area between the sub-zones of the first zone. With such design, metal area 410 is also divided symmetrically.

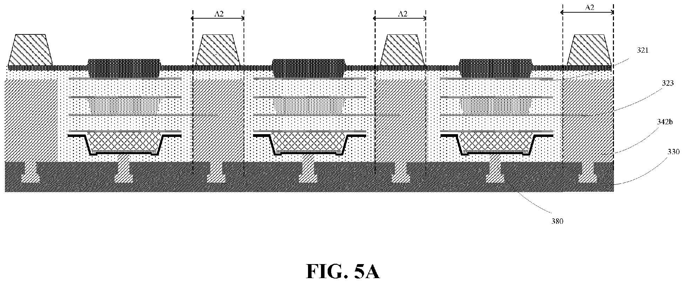

Referring back to **FIGs. 4A** to **4C****,** and consistent with **FIG. 3****,** conductive layer 321 can be extended to zone A1 to connect with bottom interconnected structure 342a; conductive layer 323 can be extended to zone A2 to connect with bottom interconnected structure 342b; and conductive layers 322 and 324 can be extended to zone B to connect with top interconnected structure 341.Further structural details are provided with reference to **FIGs. 5A** to **5C****.** In some embodiments, a sum of contours of the conductive layers connecting to a micro-LED is not less than a perimeter of the micro pixel area. That is, referring to **FIG. 4D****,** a sum of the contours of zone A1 and A2 connecting with one micro-LED is not less than a half (e.g., 50%) of the perimeter of the micro pixel area (e.g., with a diameter D).

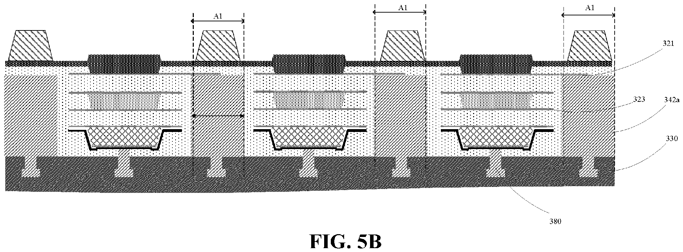

**FIG. 5A**illustrates a structural diagram showing a section view along an X axis of the exemplary micro-LED display panel 400 shown in **FIG. 4D****,** according to some embodiments of the present disclosure. **FIG. 5B** illustrates a structural diagram showing a section view along a Y axis of the exemplary micro-LED display panel 400 shown in **FIG. 4D****,** according to some embodiments of the present disclosure. As shown in **FIG. 5A****,** bottom conductive layer 323 of second light emitting layer 312 is extended to connect to bottom interconnected structure 342b. Bottom interconnected structure 342b is connected to IC backplane 330 and formed under sub-zone A2. Bottom conductive layer 321 of first light emitting layer 311 is not connected with bottom interconnected structure 342b. In some embodiments, a width of bottom interconnected structure 342b is the same as a length of sub-zone A2, that is, a distance between adjacent micro-LEDs in an X axis direction. In some embodiments, the width of bottom interconnected structure 342b is less than a length of sub-zone A2. In some embodiments, bottom conductive layer 323 can extend through bottom interconnected structure 342b, that is, bottom conductive layer 323 can extend to a furthest edge of interconnected structure 342b. In some embodiments, bottom conductive layer 323 can extend into bottom interconnected structure 342b, and terminate at any position within the bottom interconnected structure 342b. For two adjacent micro-LEDs, bottom conductive layer 323 of second light emitting layer 312 of each micro-LED can extend to and connect to one bottom interconnected structure 342b, and one bottom interconnected structure 342b can only be connected with one bottom conductive layer 323. For example, in this example, bottom conductive layer 323 of second light emitting layer 312 of each micro-LED extends right-wards (as viewed in **FIG. 5A****)** to connect with bottom interconnected structure 342b provided on the right side of the micro-LED, and does not connect with the bottom interconnected structure 342b on the left side (in a relative direction shown in **FIG. 5A****),** which is configured to connect to a bottom conductive layer of second light emitting layer 312 of the adjacent micro-LED. Therefore, one bottom interconnected structure 342b can only connect the second light emitting layer 312 of one micro-LED to the IC backplane 330. Accordingly, second light emitting layer 312 of each micro-LED can be controlled independently.

Referring to **FIG. 5B****,** similar to **FIG. 5A****,** bottom conductive layer 321 of first light emitting layer 311 is extended to connect to bottom interconnected structure 342a. Bottom interconnected structure 342a is connected to IC backplane 330 and formed under zone A1. Bottom conductive layer 323 of second light emitting layer 312 is not connected to bottom interconnected structure 342a. In some embodiments, a width of bottom interconnected structure 342a is the same as a length of sub-zone A1, that is, a distance between adjacent micro-LEDs in the Y axis direction. In some embodiments, the width of bottom interconnected structure 342a is less than a length of sub-zone A1. In some embodiments, bottom conductive layer 321 can extend through bottom interconnected structure 342a, that is, bottom conductive layer 321 can extend to a furthest edge of interconnected structure 342a. In some embodiments, bottom conductive layer 321 can extend into bottom interconnected structure 342a, and terminate at any position within the bottom interconnected structure 342a. For two adjacent micro-LEDs, bottom conductive layer 321 of first light emitting layer 311 of each micro-LED can extend to and connect to one bottom interconnected structure 342a, and one bottom interconnected structure 342a can only be connected with one bottom conductive layer 321. For example, in this example, bottom conductive layer 321 of first light emitting layer 311 of each micro-LED extends right-wards (as viewed in **FIG. 5B****)** to connect with bottom interconnected structure 342a provided on the right side, and does not connect with the bottom interconnected structure 342a on the left side (in a relative direction shown in **FIG. 5B****),** which is configured to connect to a bottom conductive layer of first light emitting layer 311 of the adjacent micro-LED. Therefore, one bottom interconnected structure 342a can only connect the first light emitting layer 311 of one micro-LED to the IC backplane 330. Accordingly, first light emitting layer 311 of each micro-LED can be controlled independently.

As shown in both **FIG. 5A** and **FIG. 5B****,** the bottom of third light emitting layer 313 can be connected to the IC backplane without a bottom conductive layer. The bottom of third light emitting layer 313 (i.e., the bottom-most light emitting layer) is connected to IC backplane 330 by bottom conductive connected structure 380. Third light emitting layer 313 is connected to IC backplane330 with a respective bottom interconnected structure for each micro-LED. Therefore, each light emitting layer of each micro-LED can be connected to IC backplane 330 separately, and thereby can be controlled independently. In some embodiments, a top of the bottom interconnected structure 342 is lower than a top of the first light emitting layer 311, i.e., the top-most light emitting layer. Therefore, the bottom interconnected structure 342 does not pass through the micro-LED.

As shown in **FIG. 5A** and **FIG. 5B****,** one bottom interconnected structure 342 is used for one light emitting layer of one micro-LED only. The adjacent micro-LEDs do not share the bottom interconnected structures. One micro-LED can be provided with a plurality of bottom interconnected structures around the micro pixel area for the multiple light emitting layers. In some embodiments, the plurality of bottom interconnected structures are arranged symmetrically around the micro pixel area.

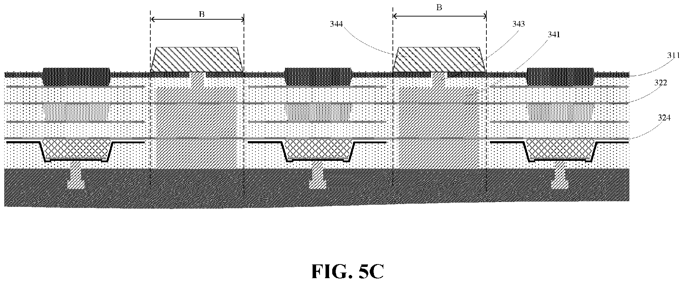

**FIG. 5C** illustrates a structural diagram showing a section view along a Z axis of the exemplary micro-LED display panel 400 shown in **FIG. 4D****,** according to some embodiments of the present disclosure. As shown in **FIG. 5C**, both top conductive layers 322 and 324 are extended and connected to top interconnected structure 341. Top interconnected structure 341 is configured to connect with the electrode of the micro-LED. In some embodiments, both top conductive layers 322 and 324 are continuously formed, that is, each top conductive layer (e.g., 322, 324) extends along the Z axis continuously. The top conductive layers of the adjacent micro-LEDs can be connected to the same top interconnected structure. For example, the four adjacent micro-LEDs can use the same top interconnected structure, which is provided at a center of the zone B. The top interconnected structures can be connected to the continuous top conductive layers 322 and 324 for all the micro-LEDs. As described with reference to **FIGs. 5A** and **5B****,** bottoms of respective light emitting layers (e.g., 311 to 313) are connected to IC backplane 330 by respective bottom interconnected structures (e.g., 342a, 342b) independently, tops of each light emitting layers can be connected to the electrode of micro-LED with a common top interconnected structure 341, which can make the design less complex, thereby reducing the cost.

In some embodiments, top interconnected structure 341 passes through the top and the bottom of the micro-LED. A top of the top interconnected structure 341 is higher than the top of the micro-LED. A bottom of the top interconnected structure 342 is formed on the IC backplane 330. In some embodiments, top interconnector structure 341 does not pass through the micro-LED, as long as top interconnector structure 341 can connect top conductive layer of the third emitting layer.

In some embodiments, the light emitting layer (i.e., 311-313) is formed by a stacked p-n junction layer. The stacked p-n junction layer includes a P-type semiconductor layer, a quantum well layer, and an N-type semiconductor layer from top to bottom. In some embodiments, any layer of the light emitting layer, e.g., a P-type semiconductor layer, a quantum well layer, and an N-type semiconductor layer is continuously formed between the adjacent micro pixel area, and continuously formed on the whole micro pixel array area. In some embodiments, a top contact 344 is directly formed on the quantum well layer between the adjacent micro-LEDs, and top contact 344 is configured to connect the electrode. The top of top interconnected structure 341 is connected with the bottom of top contact 344. Therefore, the two adjacent micro-LEDs can share one top contact 344 and one top interconnected structure 341. In some embodiments, the P-type semiconductor layer and/or the N-type semiconductor layer include III-V group compound semiconductors.

In some embodiments, an opening is formed in the quantum well of the first light emitting layer 311 between the adjacent micro-LEDs. A top conductive connected structure 343 is formed through the opening and is connected with top interconnected structure 341 and top contact 344. A width of the top conductive connected structure 343 is less than a width of top interconnected structure 341. A width of top contact 344 is greater than the width of the top conductive connected structure 343. In some embodiments, the width of top contact 344 is further greater than the width of top interconnected structure 341, to improve the conductive performance of top interconnected structure 341. In some embodiments, the width of top contact 344 is greater than a width of bottom interconnected structure 342. Therefore, a volume of the micro-LED can be decrease and integration degree is improved.

In some embodiments, a plurality of the top contacts are continuously connected to form a mesh structure. The mesh structure includes a plurality of openings, and each of the micro-LED is exposed from the opening. The size (e.g., an area) of the opening is flexible, as long as the mesa structure area of the micro-LED is exposed.

The micro-LED display panel provided by the embodiments of the present disclosure, has interconnected structures for connecting each light emitting layer of each micro-LED to connect electrodes, and the interconnected structures are provided symmetrically on the micro-LED display panel, which may facilitate manufacture of the micro-LED display panel. The conductive layer network structure corresponds to the interconnected structures which may further reduce metal usage with the symmetrical arrangement.

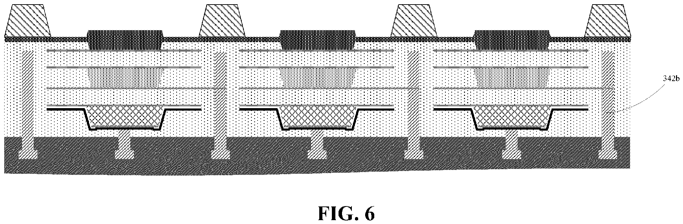

**FIG. 6** illustrates a structural diagram showing a section view along an X axis of another exemplary micro-LED display panel, according to some embodiments of the present disclosure. Compared with **FIG. 5A****,** a width of the bottom interconnected structure 342b show in **FIG. 6** is less than a width of the bottom interconnected structure 342b shown in **FIG. 5A****.** Therefore, the micro-LED can be arranged more compactly, and for a given micro-LED display panel, more micro-LEDs can be arranged.

The micro-LED herein has a very small volume. The micro-LED may be an organic LED or an inorganic LED. The micro-LED can be applied in a micro-LED array panel. The light emitting area of the micro-LED array panel is very small, such as 1mm×1mm, 3mm×5 mm, etc. In some embodiments, the light emitting area is the area of the micro-LED array in the micro-LED array panel. The micro-LED array panel includes one or more micro-LED arrays that form a pixel array in which the micro-LEDs are pixels, such as a 1600×1200, 680×480, or 1920×1080-pixel array. The diameter of the micro-LED is in the range of about 200nm to 2µm. An IC backplane is formed at the back surface of the micro-LED array and is electrically connected with the micro-LED array. The IC backplane acquires signals such as image data from outside via signal lines to control corresponding micro-LEDs to emit light or not.

It is understood by those skilled in the art that the micro-LED display model or the micro-LED display panel is not limited by the structure described above, and may include greater or fewer components than those illustrated, or some components may be combined, or a different component may be utilized.

It should be noted that relational terms herein such as "first" and "second" are used only to differentiate an entity or operation from another entity or operation, and do not require or imply any actual relationship or sequence between these entities or operations. Moreover, the words "comprising," "having," "containing," and "including," and other similar forms are intended to be equivalent in meaning and be open ended in that an item or items following any one of these words is not meant to be an exhaustive listing of such item or items, or meant to be limited to only the listed item or items.

The following clauses provide additional information regarding embodiments of the disclosure:
1. A micro-LED display panel, comprising:
   a micro pixel array area comprising a plurality of micro pixel areas, each micro pixel area comprising a micro-LED; wherein the micro-LED comprises at least two light emitting layers disposed in a vertical direction and a dielectric layer formed between adjacent ones of the light emitting layers, wherein the at least two light emitting layers are coaxial;
   an IC backplane formed at a back surface of the micro-LED and configured to control the light emitting layers; and
   a plurality of interconnected structures configured to electrically respectively connect the light emitting layer to electrodes, wherein the interconnected structures comprises one or more top interconnected structures configured to electrically connect a top of each of the light emitting layers to a first electrode, and one or more bottom interconnected structures configured to electrically connect a bottom of each of the light emitting layers to the IC backplane to a second electrode, the interconnected structures being formed around each micro pixel area, one bottom interconnected structure corresponding to one micro-LED, and one top interconnected structure corresponding to adjacent micro-LEDs.
2. The micro-LED display panel according to clause1, wherein the plurality of inter connected structures are symmetrically arranged in the micro-LED display panel around each micro-LED.
3. The micro-LED display panel according to clause 1 or 2, wherein the interconnected structure is not directly connected with any of the light emitting layers.
4. The micro-LED display panel according to clause 3, wherein the micro-LED comprises three or more light emitting layers in the vertical direction; and the interconnected structures comprise two or more bottom interconnected structures which are respectively electrically connected with a bottom of each light emitting layer except for a bottom-most light emitting layer of the micro-LED.
5. The micro-LED display panel according to clause 4, wherein a bottom of the bottom-most light emitting layer is connected to the IC backplane by a bottom conductive connected structure which is formed between a bottom of the bottom-most light emitting layer and the IC backplane.
6. The micro-LED display panel according to clause 4 or 5, wherein a number of the bottom interconnected structures for the micro-LED is equal to a number of the light emitting layers of the micro-LED minus one.
7. The micro-LED display panel according to any one of clauses3 to 6, wherein the light emitting layers comprise first, second, and third light emitting layers disposed in the vertical direction, the bottom interconnected structures include first bottom interconnected structures for connecting a bottom of the first light emitting layer of each of the micro-LEDs and second bottom interconnected structures for connecting a bottom of the second light emitting layer of each of the micro-LEDs; and the first bottom interconnected structures and second bottom interconnected structures are symmetrically arranged in the micro-LED display panel around each micro pixel area.
8. The micro-LED display panel according to clause 7, wherein the top interconnected structure is symmetrically arranged in the micro-LED display panel.
9. The micro-LED display panel according to clause 7 or 8, wherein a symmetric center is a center of the micro-LED.
10. The micro-LED display panel according to any one of clauses 1 to 9, further comprising a conductive layer network structure configured to connect the light emitting layer to the interconnected structure.
11. The micro-LED display panel according to clause 10, wherein the conductive layer network structure comprises one or more top conductive layers formed on a top surface of each of the light emitting layers to connect the light emitting layers with the top interconnected structures, and one or more bottom conductive layers formed at a bottom surface of each of light emitting layers to connect the light emitting layers with the bottom interconnected structures.
12. The micro-LED display panel according to clause 11, wherein each of the top conductive layers is continuously formed between adjacent micro-LEDs; and each of the bottom conductive layers is not continuous between the adjacent micro-LEDs, and the bottom interconnected structures are separately connected with the corresponding bottom conductive layers of each of the micro-LEDs.
13. The micro-LED display panel according to any one of clauses 10 to 12, wherein the conductive layer network structure is transparent.
14. The micro-LED display panel according to clause 13, wherein a material of the conductive layer network structure is one of Indium Tin Oxides (ITO), Fluorine-doped Tin Oxide (FTO), or Aluminum-doped Zinc Oxide (AZO).
15. The micro-LED display panel according to clause 12, wherein a bottom conductive layer of a bottom-most light emitting layer is non-transparent.
16. The micro-LED display panel according to any one of clauses 10 to 15, wherein a sum of contours of the conductive layers connecting to the micro-LED is not less than a half of a perimeter of the micro pixel area.
17. The micro-LED display panel according to any one of clauses 1 to 16, further comprising a dielectric layer formed between the light emitting layers and around the interconnected structures.
18. The micro-LED display panel according to clause 17, wherein the dielectric layer is transparent.
19. The micro-LED display panel according to any one of clauses1 to 18, wherein the bottom interconnected structure is formed on a top surface of the IC back plane and electrically connected with the IC back plane.
20. The micro-LED display panel according to clause 19, wherein a top of the bottom interconnected structures is lower than a top of a top-most light emitting layer.
21. The micro-LED display panel according to any one of clauses1 to 20, wherein the top interconnected structures pass through a top and a bottom of the micro-LED, and the top of the top interconnected structure is higher than the top of the micro-LEDs.
22. The micro-LED display panel according to clause21, wherein the light emitting layer is formed by a stacked P-N junction layer, the stacked P-N junction layer comprising a P-type semiconductor layer, a quantum well layer, and an N-type semiconductor layer.
23. The micro-LED display panel according to clause 22, wherein the P-type semiconductor layer and/or the N-type semiconductor layer comprise III-V group compound semiconductors.
24. The micro-LED display panel according to clause 22 or 23, wherein the quantum well layer of a top-most light emitting layer is continuously formed between adjacent micro-LEDs and continuously formed on the micro pixel array area.
25. The micro-LED display panel according to clause 24, wherein a top contact is provided on the quantum well layer between the adjacent micro-LEDs.
26. The micro-LED display panel according to clause 25, wherein an opening is formed in the quantum well layer between the adjacent micro-LEDs; and a top conductive connected structure is provided through the opening to connect the top interconnected structure with the top contact.
27. The micro-LED display panel according to clause 26, wherein a plurality of the top contacts are continuously connected to form a mesh structure with the micro-LED being exposed.
28. The micro-LED display panel according to clause 26 or 27, wherein a width of the top conductive connected structure is less than a width of the top interconnected structure; and a width of the top contact is larger than the width of the top conductive connected structure.
29. The micro-LED display panel according to clause 28, wherein the width of the top contact is larger than the width of the top interconnected structure.
30. The micro-LED display panel according to clause 29, wherein the width of the top contact is larger than a width of the bottom interconnected structure.
31. The micro-LED display panel according to any one of clauses 1 to 30, wherein the interconnected structures are made of conductive metal.
32. The micro-LED display panel according to any one of clauses 1 to 31, wherein the light emitting layers emit at least two different colors of light.
33. The micro-LED display panel according to clause 32, wherein the light emitting layers comprise a red light emitting layer, a blue light emitting layer, and a green light emitting layer.
34. The micro-LED display panel according to clause 32, wherein the light emitting layers comprise two red light emitting layers and a green light emitting layer.
35. The micro-LED display panel according to clause 1 to 31, wherein the light emitting layers emit a same color of light.
36. The micro-LED display panel according to any one of clauses 1 to 35, wherein the micro-LED further comprises a mesa structure formed by the light emitting layer.
37. The micro-LED display panel according to clause 36, wherein the mesa structure comprises a flat top surface.
38. The micro-LED display panel according to clause 37, wherein the mesa structure comprises a convex structure.
39. The micro-LED display panel according to clause 37, wherein a surface of the mesa structure is aligned with a surface of the micro-LED.
40. The micro-LED display panel according to any one of clauses36 to 39, wherein the micro-LED further comprises a micro lens provided above the first light emitting layer, covering an area of the mesa structure.
41. The micro-LED display panel according to any one of clauses 1 to 40, further comprising a reflective layer formed on a bottom surface of a bottom-most light emitting layer of the at least two light emitting layers.
42. The micro-LED display panel according to any one of clauses 1 to 41, wherein the plurality of interconnected structures are configured to reflect light emitted from the at least two light emitting layers.
43. The micro-LED display panel according to any one of clauses 1 to 42, further comprising an external wire configured to connecting the top interconnected structures to the first electrode, wherein the first electrode is provided on the IC backplane.
44. A micro-LED display panel, comprising:
   a micro pixel array area comprising a plurality of micro pixel areas, each micro pixel area comprising a micro-LED; wherein the micro-LED comprises at least two light emitting layers disposed in a vertical direction and a dielectric layer formed between adjacent ones of the light emitting layers, wherein the at least two light emitting layers are off-axial;
   an IC backplane formed at a back surface of the micro-LED and configured to control the light emitting layers; and
   a plurality of interconnected structures configured to electrically respectively connect the light emitting layer to electrodes, wherein the interconnected structures comprises one or more top interconnected structures configured to electrically connect a top of each of the light emitting layers to a first electrode, and one or more bottom interconnected structures configured to electrically connect a bottom of each of the light emitting layers to the IC backplane to a second electrode, the interconnected structures being formed around each micro pixel area, one bottom interconnected structure corresponding to one micro-LED, and one top interconnected structure corresponding to adjacent micro-LEDs.
45. The micro-LED display panel according to clause 44, wherein the at least two light emitting layers are staggered.
46. The micro-LED display panel according to clause 44, wherein the plurality of interconnected structures are symmetrically arranged in the micro-LED display panel around each micro-LED.
47. The micro-LED display panel according to any one of clauses 44 to 46, wherein the interconnected structure is not directly connected with any of the light emitting layers.
48. The micro-LED display panel according to clause 47, wherein the micro-LED comprises three or more light emitting layers in the vertical direction; and the interconnected structures comprise two or more bottom interconnected structures which are respectively electrically connected with a bottom of each light emitting layer except for a bottom-most light emitting layer of the micro-LED.
49. The micro-LED display panel according to clause 48, wherein a bottom of the bottom-most light emitting layer is connected to the IC backplane by a bottom conductive connected structure which is formed between a bottom of the bottom-most light emitting layer and the IC backplane.
50. The micro-LED display panel according to clause 48 or 49, wherein a number of the bottom interconnected structures for the micro-LED is equal to a number of the light emitting layers of the micro-LED minus one.
51. The micro-LED display panel according to any one of clauses 47 to 50, wherein the light emitting layers comprise first, second, and third light emitting layers disposed in the vertical direction, the bottom interconnected structures include first bottom interconnected structures for connecting a bottom of the first light emitting layer of each of the micro-LEDs and second bottom interconnected structures for connecting a bottom of the second light emitting layer of each of the micro-LEDs; and the first bottom interconnected structures and second bottom interconnected structures are symmetrically arranged in the micro-LED display panel around each micro pixel area.
52. The micro-LED display panel according to clause 51, wherein the top interconnected structure is symmetrically arranged in the micro-LED display panel.
53. The micro-LED display panel according to clause 51 or 52, wherein a symmetric center is a center of the micro-LED.
54. The micro-LED display panel according to any one of clauses 44 to 53, further comprising a conductive layer network structure configured to connect the light emitting layer to the interconnected structure.
55. The micro-LED display panel according to clause 54, wherein the conductive layer network structure comprises one or more top conductive layers formed on a top surface of each of the light emitting layers to connect the light emitting layers with the top interconnected structures, and one or more bottom conductive layers formed at a bottom surface of each of light emitting layers to connect the light emitting layers with the bottom interconnected structures.
56. The micro-LED display panel according to clause 55, wherein each of the top conductive layers is continuously formed between adjacent micro-LEDs; and each of the bottom conductive layers is not continuous between the adjacent micro-LEDs, and the bottom interconnected structures are separately connected with the corresponding bottom conductive layers of each of the micro-LEDs.
57. The micro-LED display panel according to any one of clauses 54 to 56, wherein the conductive layer network structure is transparent.
58. The micro-LED display panel according to clause 57, wherein a material of the conductive layer network structure is one of Indium Tin Oxides (ITO), Fluorine-doped Tin Oxide (FTO), or Aluminum-doped Zinc Oxide (AZO).
59. The micro-LED display panel according to clause 56, wherein a bottom conductive layer of a bottom-most light emitting layer is non-transparent.
60. The micro-LED display panel according to any one of clauses 54 to 59, wherein a sum of contours of the conductive layers connecting to the micro-LED is not less than a half of a perimeter of the micro pixel area.
61. The micro-LED display panel according to any one of clauses 44 to 60, further comprising a dielectric layer formed between the light emitting layers and around the interconnected structures.
62. The micro-LED display panel according to clause 61, wherein the dielectric layer is transparent.
63. The micro-LED display panel according to any one of clauses 44 to 62, wherein the bottom interconnected structure is formed on a top surface of the IC back plane and electrically connected with the IC back plane.
64. The micro-LED display panel according to clause 63, wherein a top of the bottom interconnected structures is lower than a top of a top-most light emitting layer.
65. The micro-LED display panel according to any one of clauses 44 to 64, wherein the top interconnected structures pass through a top and a bottom of the micro-LED, and the top of the top interconnected structure is higher than the top of the micro-LEDs.
66. The micro-LED display panel according to clause 65, wherein the light emitting layer is formed by a stacked P-N junction layer, the stacked P-N junction layer comprising a P-type semiconductor layer, a quantum well layer, and an N-type semiconductor layer.
67. The micro-LED display panel according to clause 66, wherein the P-type semiconductor layer and/or the N-type semiconductor layer comprise III-V group compound semiconductors.
68. The micro-LED display panel according to clause 66 or 67, wherein the quantum well layer of a top-most light emitting layer is continuously formed between adjacent micro-LEDs and continuously formed on the micro pixel array area.
69. The micro-LED display panel according to clause 68, wherein a top contact is provided on the quantum well layer between the adjacent micro-LEDs.
70. The micro-LED display panel according to clause 69, wherein an opening is formed in the quantum well layer between the adjacent micro-LEDs; and a top conductive connected structure is provided through the opening to connect the top interconnected structure with the top contact.
71. The micro-LED display panel according to clause 70, wherein a plurality of the top contacts are continuously connected to form a mesh structure with the micro-LED being exposed.
72. The micro-LED display panel according to clause 70 or 71, wherein a width of the top conductive connected structure is less than a width of the top interconnected structure; and a width of the top contact is larger than the width of the top conductive connected structure.
73. The micro-LED display panel according to clause 72, wherein the width of the top contact is larger than the width of the top interconnected structure.
74. The micro-LED display panel according to clause 73, wherein the width of the top contact is larger than a width of the bottom interconnected structure.
75. The micro-LED display panel according to any one of clauses 44 to 74, wherein the interconnected structures are made of conductive metal.
76. The micro-LED display panel according to any one of clauses 44 to 75, wherein the light emitting layers emit at least two different colors of light.
77. The micro-LED display panel according to clause 76, wherein the light emitting layers comprise a red light emitting layer, a blue light emitting layer, and a green light emitting layer.
78. The micro-LED display panel according to clause 76, wherein the light emitting layers comprise two red light emitting layers and a green light emitting layer.
79. The micro-LED display panel according to clause 44 to 75, wherein the light emitting layers emit a same color of light.
80. The micro-LED display panel according to any one of clauses 44 to 79, wherein the micro-LED further comprises a mesa structure formed by the light emitting layer.
81. The micro-LED display panel according to clause 80, wherein the mesa structure comprises a flat top surface.
82. The micro-LED display panel according to clause 81, wherein the mesa structure comprises a convex structure.
83. The micro-LED display panel according to clause 81, wherein a surface of the mesa structure is aligned with a surface of the micro-LED.
84. The micro-LED display panel according to any one of clauses 80 to 83, wherein the micro-LED further comprises a micro lens provided above the first light emitting layer, covering an area of the mesa structure.
85. The micro-LED display panel according to any one of clauses 44 to 84, further comprising a reflective layer formed on a bottom surface of a bottom-most light emitting layer of the at least two light emitting layers.
86. The micro-LED display panel according to any one of clauses 44 to 85, wherein the plurality of interconnected structures are configured to reflect light emitted from the at least two light emitting layers.
87. The micro-LED display panel according to any one of clauses 44 to 86, further comprising an external wire configured to connecting the top interconnected structures to the first electrode, wherein the first electrode is provided on the IC backplane.
88. A micro-LED display panel, comprising:
   a micro pixel array area comprising a plurality of micro pixel areas, each micro pixel area comprising a micro-LED; wherein the micro-LED comprises at least two light emitting layers disposed in a vertical direction and a dielectric layer formed between adjacent ones of the light emitting layers;
   an IC backplane formed at a back surface of the micro-LED and configured to control the light emitting layers;
   a plurality of interconnected structures configured to electrically respectively connect the light emitting layer to electrodes, wherein the interconnected structures comprises one or more top interconnected structures configured to electrically connect a top of each of the light emitting layers to a first electrode, and one or more bottom interconnected structures configured to electrically connect a bottom of each of the light emitting layers to the IC backplane to a second electrode, the interconnected structures being formed around each micro pixel area, one bottom interconnected structure corresponding to one micro-LED, and one top interconnected structure corresponding to adjacent micro-LEDs; and
   a plurality of the top contacts configured to connect the one or more top interconnected structures to the first electrode, wherein the top contacts are continuously connected to form a mesh structure with the micro-LED being exposed.
89. The micro-LED display panel according to clause 88, wherein the plurality of interconnected structures are symmetrically arranged in the micro-LED display panel around each micro-LED.
90. The micro-LED display panel according to clause 88 or 89, wherein the interconnected structure is not directly connected with any of the light emitting layers.
91. The micro-LED display panel according to clause 90, wherein the micro-LED comprises three or more light emitting layers in the vertical direction; and the interconnected structures comprise two or more bottom interconnected structures which are respectively electrically connected with a bottom of each light emitting layer except for a bottom-most light emitting layer of the micro-LED.
92. The micro-LED display panel according to clause 91, wherein a bottom of the bottom-most light emitting layer is connected to the IC backplane by a bottom conductive connected structure which is formed between a bottom of the bottom-most light emitting layer and the IC backplane.
93. The micro-LED display panel according to clause 91 or 92, wherein a number of the bottom interconnected structures for the micro-LED is equal to a number of the light emitting layers of the micro-LED minus one.
94. The micro-LED display panel according to any one of clauses 90 to 93, wherein the light emitting layers comprise first, second, and third light emitting layers disposed in the vertical direction, the bottom interconnected structures include first bottom interconnected structures for connecting a bottom of the first light emitting layer of each of the micro-LEDs and second bottom interconnected structures for connecting a bottom of the second light emitting layer of each of the micro-LEDs; and the first bottom interconnected structures and second bottom interconnected structures are symmetrically arranged in the micro-LED display panel around each micro pixel area.
95. The micro-LED display panel according to clause 94, wherein the top interconnected structure is symmetrically arranged in the micro-LED display panel.
96. The micro-LED display panel according to clause 94 or 95, wherein a symmetric center is a center of the micro-LED.
97. The micro-LED display panel according to any one of clauses 88 to 96, further comprising a conductive layer network structure configured to connect the light emitting layer to the interconnected structure.
98. The micro-LED display panel according to clause 99, wherein the conductive layer network structure comprises one or more top conductive layers formed on a top surface of each of the light emitting layers to connect the light emitting layers with the top interconnected structures, and one or more bottom conductive layers formed at a bottom surface of each of light emitting layers to connect the light emitting layers with the bottom interconnected structures.
99. The micro-LED display panel according to clause 98, wherein each of the top conductive layers is continuously formed between adjacent micro-LEDs; and each of the bottom conductive layers is not continuous between the adjacent micro-LEDs, and the bottom interconnected structures are separately connected with the corresponding bottom conductive layers of each of the micro-LEDs.
100. The micro-LED display panel according to any one of clauses 97 to 99, wherein the conductive layer network structure is transparent.
101. The micro-LED display panel according to clause 100, wherein a material of the conductive layer network structure is one of Indium Tin Oxides (ITO), Fluorine-doped Tin Oxide (FTO), or Aluminum-doped Zinc Oxide (AZO).
102. The micro-LED display panel according to clause 101, wherein a bottom conductive layer of a bottom-most light emitting layer is non-transparent.
103. The micro-LED display panel according to any one of clauses 97 to 102, wherein a sum of contours of the conductive layers connecting to the micro-LED is not less than a half of a perimeter of the micro pixel area.
104. The micro-LED display panel according to any one of clauses 88 to 103, further comprising a dielectric layer formed between the light emitting layers and around the interconnected structures.
105. The micro-LED display panel according to clause 104, wherein the dielectric layer is transparent.
106. The micro-LED display panel according to any one of clauses 88 to 105, wherein the bottom interconnected structure is formed on a top surface of the IC back plane and electrically connected with the IC back plane.
107. The micro-LED display panel according to clause 106, wherein a top of the bottom interconnected structures is lower than a top of a top-most light emitting layer.
108. The micro-LED display panel according to any one of clauses 88 to 107, wherein the top interconnected structures pass through a top and a bottom of the micro-LED, and the top of the top interconnected structure is higher than the top of the micro-LEDs.
109. The micro-LED display panel according to clause 108, wherein the light emitting layer is formed by a stacked P-N junction layer, the stacked P-N junction layer comprising a P-type semiconductor layer, a quantum well layer, and an N-type semiconductor.
110. The micro-LED display panel according to clause 109, wherein the P-type semiconductor layer and/or the N-type semiconductor layer comprise III-V group compound semiconductors.
111. The micro-LED display panel according to clause 109 or 110, wherein the quantum well layer of a top-most light emitting layer is continuously formed between adjacent micro-LEDs and continuously formed on the micro pixel array area.
112. The micro-LED display panel according to clause 111, wherein the top contact is provided on the quantum well layer between the adjacent micro-LEDs.
113. The micro-LED display panel according to clause 112, wherein an opening is formed in the quantum well layer between the adjacent micro-LEDs; and a top conductive connected structure is provided through the opening to connect the top interconnected structure with the top contact.
114. The micro-LED display panel according to clause 113, wherein a width of the top conductive connected structure is less than a width of the top interconnected structure; and a width of the top contact is larger than the width of the top conductive connected structure.
115. The micro-LED display panel according to clause 114, wherein the width of the top contact is larger than the width of the top interconnected structure.
116. The micro-LED display panel according to clause 115, wherein the width of the top contact is larger than a width of the bottom interconnected structure.
117. The micro-LED display panel according to any one of clauses 88 to 116, wherein the interconnected structures are made of conductive metal.
118. micro-LED display panel according to any one of clauses 88 to 117, wherein the light emitting layers emit at least two different colors of light.
119. The micro-LED display panel according to clause 118, wherein the light emitting layers comprise a red light emitting layer, a blue light emitting layer, and a green light emitting layer.
120. The micro-LED display panel according to clause 118, wherein the light emitting layers comprise two red light emitting layers and a green light emitting layer.
121. The micro-LED display panel according to clause 88 to 117, wherein the light emitting layers emit a same color of light.
122. The micro-LED display panel according to any one of clauses 1 to 121, wherein the micro-LED further comprises a mesa structure formed by the light emitting layer.
123. The micro-LED display panel according to clause 122, wherein the mesa structure comprises a flat top surface.
124. The micro-LED display panel according to clause 123, wherein the mesa structure comprises a convex structure.
125. The micro-LED display panel according to clause 123, wherein a surface of the mesa structure is aligned with a surface of the micro-LED.
126. The micro-LED display panel according to any one of clauses 122 to 125, wherein the micro-LED further comprises a micro lens provided above the first light emitting layer, covering an area of the mesa structure.
127. The micro-LED display panel according to any one of clauses 88 to 126, further comprising a reflective layer formed on a bottom surface of a bottom-most light emitting layer of the at least two light emitting layers.
128. The micro-LED display panel according to any one of clauses 88 to 127, wherein the plurality of interconnected structures are configured to reflect light emitted from the at least two light emitting layers.
129. The micro-LED display panel according to any one of clauses 88 to 128, further comprising an external wire configured to connecting the top interconnected structures to the first electrode, wherein the first electrode is provided on the IC backplane.

As used herein, unless specifically stated otherwise, the term "or" encompasses all possible combinations, except where infeasible. For example, if it is stated that a database may include A or B, then, unless specifically stated otherwise or infeasible, the database may include A, or B, or A and B. As a second example, if it is stated that a database may include A, B, or C, then, unless specifically stated otherwise or infeasible, the database may include A, or B, or C, or A and B, or A and C, or B and C, or A and B and C.

In the foregoing specification, embodiments have been described with reference to numerous specific details that can vary from implementation to implementation. Certain adaptations and modifications of the described embodiments can be made. Other embodiments can be apparent to those skilled in the art from consideration of the specification and practice of the invention disclosed herein. It is intended that the specification and examples be considered as exemplary only, with a true scope and spirit of the invention being indicated by the following claims. It is also intended that the sequence of steps shown in figures are only for illustrative purposes and are not intended to be limited to any particular sequence of steps. As such, those skilled in the art can appreciate that these steps can be performed in a different order while implementing the same method.

In the drawings and specification, there have been disclosed exemplary embodiments. However, many variations and modifications can be made to these embodiments. Accordingly, although specific terms are employed, they are used in a generic and descriptive sense only and not for purposes of limitation.

## Claims

1. A micro-LED display panel, comprising:
a micro pixel array area comprising a plurality of micro pixel areas, each micro pixel area comprising a micro-LED; wherein the micro-LED comprises at least two light emitting layers disposed in a vertical direction and a dielectric layer formed between adjacent ones of the light emitting layers, wherein the at least two light emitting layers are off-axial;
an IC backplane formed at a back surface of the micro-LED and configured to control the light emitting layers; and
a plurality of interconnected structures configured to electrically respectively connect the light emitting layer to electrodes, wherein the interconnected structures comprises one or more top interconnected structures configured to electrically connect a top of each of the light emitting layers to a first electrode, and one or more bottom interconnected structures configured to electrically connect a bottom of each of the light emitting layers to the IC backplane to a second electrode, the interconnected structures being formed around each micro pixel area, one bottom interconnected structure corresponding to one micro-LED, and one top interconnected structure corresponding to adjacent micro-LEDs.

2. The micro-LED display panel according to claim 1, wherein the at least two light emitting layers are staggered.

3. The micro-LED display panel according to claim 1, wherein the plurality of interconnected structures are symmetrically arranged in the micro-LED display panel around each micro-LED.

4. The micro-LED display panel according to any one of claims 1 to 2, wherein the interconnected structure is not directly connected with any of the light emitting layers, optionally wherein the micro-LED comprises three or more light emitting layers in the vertical direction; and the interconnected structures comprise two or more bottom interconnected structures which are respectively electrically connected with a bottom of each light emitting layer except for a bottom-most light emitting layer of the micro-LED, optionally wherein a bottom of the bottom-most light emitting layer is connected to the IC backplane by a bottom conductive connected structure which is formed between a bottom of the bottom-most light emitting layer and the IC backplane, wherein a number of the bottom interconnected structures for the micro-LED is optionally equal to a number of the light emitting layers of the micro-LED minus one, optionally wherein the light emitting layers comprise first, second, and third light emitting layers disposed in the vertical direction, the bottom interconnected structures include first bottom interconnected structures for connecting a bottom of the first light emitting layer of each of the micro-LEDs and second bottom interconnected structures for connecting a bottom of the second light emitting layer of each of the micro-LEDs; and the first bottom interconnected structures and second bottom interconnected structures are symmetrically arranged in the micro-LED display panel around each micro pixel area, optionally wherein the top interconnected structure is symmetrically arranged in the micro-LED display panel, and wherein a symmetric center is optionally a center of the micro-LED.

5. The micro-LED display panel according to any one of claims 1 to 4, further comprising a conductive layer network structure configured to connect the light emitting layer to the interconnected structure, optionally wherein the conductive layer network structure comprises one or more top conductive layers formed on a top surface of each of the light emitting layers to connect the light emitting layers with the top interconnected structures, and one or more bottom conductive layers formed at a bottom surface of each of light emitting layers to connect the light emitting layers with the bottom interconnected structures, optionally wherein each of the top conductive layers is continuously formed between adjacent micro-LEDs; and each of the bottom conductive layers is not continuous between the adjacent micro-LEDs, and the bottom interconnected structures are separately connected with the corresponding bottom conductive layers of each of the micro-LEDs.

6. The micro-LED display panel according to claim 5, wherein the conductive layer network structure is transparent, wherein a material of the conductive layer network structure is optionally one of Indium Tin Oxides (ITO), Fluorine-doped Tin Oxide (FTO), or Aluminum-doped Zinc Oxide (AZO), wherein a bottom conductive layer of a bottom-most light emitting layer is optionally non-transparent, and wherein a sum of contours of the conductive layers connecting to the micro-LED is optionally not less than a half of a perimeter of the micro pixel area.

7. The micro-LED display panel according to any one of claims 1 to 6, further comprising a dielectric layer formed between the light emitting layers and around the interconnected structures, wherein the dielectric layer is optionally transparent.

8. The micro-LED display panel according to any one of claims 1 to 7, wherein the bottom interconnected structure is formed on a top surface of the IC back plane and electrically connected with the IC back plane, wherein a top of the bottom interconnected structures is optionally lower than a top of a top-most light emitting layer.

9. The micro-LED display panel according to any one of claims 1 to 8, wherein the top interconnected structures pass through a top and a bottom of the micro-LED, and the top of the top interconnected structure is higher than the top of the micro-LEDs, optionally wherein the light emitting layer is formed by a stacked P-N junction layer, the stacked P-N junction layer comprising a P-type semiconductor layer, a quantum well layer, and an N-type semiconductor layer, wherein the P-type semiconductor layer and/or the N-type semiconductor layer optionally comprise III-V group compound semiconductors, wherein the quantum well layer of a top-most light emitting layer is optionally continuously formed between adjacent micro-LEDs and continuously formed on the micro pixel array area, wherein a top contact is optionally provided on the quantum well layer between the adjacent micro-LEDs, optionally wherein an opening is formed in the quantum well layer between the adjacent micro-LEDs; and a top conductive connected structure is provided through the opening to connect the top interconnected structure with the top contact, wherein a plurality of the top contacts are optionally continuously connected to form a mesh structure with the micro-LED being exposed, optionally wherein a width of the top conductive connected structure is less than a width of the top interconnected structure; and a width of the top contact is larger than the width of the top conductive connected structure, wherein the width of the top contact is optionally larger than the width of the top interconnected structure, and wherein the width of the top contact is optionally larger than a width of the bottom interconnected structure.

10. The micro-LED display panel according to any one of claims 1 to 9, wherein the interconnected structures are made of conductive metal.

11. The micro-LED display panel according to any one of claims 1 to 10, wherein the light emitting layers emit at least two different colors of light, optionally wherein the light emitting layers comprise a red light emitting layer, a blue light emitting layer, and a green light emitting layer, or two red light emitting layers and a green light emitting layer.

12. The micro-LED display panel according to claim 1 to 10, wherein the light emitting layers emit a same color of light.

13. The micro-LED display panel according to any one of claims 1 to 12, wherein the micro-LED further comprises a mesa structure formed by the light emitting layer, wherein the mesa structure optionally comprises a flat top surface and/or a convex structure, wherein a surface of the mesa structure is optionally aligned with a surface of the micro-LED, and wherein the micro-LED optionally comprises a micro lens provided above the first light emitting layer, covering an area of the mesa structure.

14. The micro-LED display panel according to any one of claims 1 to 13, further comprising a reflective layer formed on a bottom surface of a bottom-most light emitting layer of the at least two light emitting layers.

15. The micro-LED display panel according to any one of claims 1 to 14, wherein the plurality of interconnected structures are configured to reflect light emitted from the at least two light emitting layers.

16. The micro-LED display panel according to any one of claims 1 to 15, further comprising an external wire configured to connecting the top interconnected structures to the first electrode, wherein the first electrode is provided on the IC backplane.
